# EUROPÄISCHE PATENTSCHRIFT

(11) **EP 3 622 589 B1**
(45) Veröffentlichungstag und Bekanntmachung des Hinweises auf die Patenterteilung: **08.06.2022**
(21) Anmeldenummer: 18720249.4
(22) Anmeldetag: 26.04.2018
(51) Int. Cl.: H01R 43/24, H05K 5/00, H05K 5/06, H05K 1/18, H05K 3/30

(54) **ELEKTRONIKMODUL UND FERTIGUNGSVERFAHREN**
ELECTRONIC MODULE AND MANUFACTURING METHOD
MODULE ÉLECTRONIQUE ET PROCÉDÉ DE FABRICATION

(30) Priorität: 08.05.2017 DE 102017207682
(43) Veröffentlichungstag der Anmeldung: 18.03.2020
(73) Patentinhaber: Robert Bosch GmbH, 70442 Stuttgart (DE)
(72) Erfinder: BRAUN, Gerhard, 72108 Rottenburg (DE); MAENZ, Torsten, 71106 Magstadt (DE)
(86) Internationale Anmeldenummer: PCT/EP2018/060688
(87) Internationale Veröffentlichungsnummer: WO 2018/206296

(56) Entgegenhaltungen:
- EP-A1- 0 653 818
- EP-A2- 1 734 800
- DE-A1-102008 043 774
- DE-A1-102015 203 592

## Beschreibung

Die Erfindung betrifft ein Elektronikmodul sowie ein Herstellverfahren für das Elektronikmodul gemäß den Oberbegriffen der unabhängigen Ansprüche.

### Stand der Technik

Herkömmliche elektronische Schaltungen, wie Sie beispielsweise für Steuergeräte von Motoren oder Airbags zum Einsatz kommen, werden für gewöhnlich in einem separaten Gehäuse verbaut. Eine elektrische Kontaktierung des Steuergerätes nach außen wird in der Regel durch einen elektrischen Stecker bereitgestellt, welcher separat in einem Spritzgussverfahren gefertigt ist. Derartige spritzgegossenen Stecker weisen beispielsweise Steckerkontakte auf, die in einem Steckerkörper eingestitcht sind. Die Stecker werden mit einem die elektronische Schaltung tragenden Schaltungsträger kontaktiert. Zur Aufnahme des Schaltungsträgers ist das Gehäuse mehrteilig ausgeführt und ist beispielsweise aus einem Aluminium-Druckguss oder aus Kunststoffkomponenten gebildet. Um die elektronische Schaltung vor Umwelteinflüssen zu schützen, ist zwischen den Gehäusekomponenten eine Dichtung erforderlich.

Schaltungen, in denen keine druckempfindlichen Bauteile verbaut werden und die zusätzlich erhöhten Umwelteinflüssen (z.B. Motoröl oder Getriebeöl) ausgesetzt sind, werden heute bereits mittels Spritzgießverfahren als Elektronikmodule verpackt. Erfolgt die äußere Kontaktierung des Elektronikmoduls mittels Steckerpins, so sind weiterhin separate Vorspritzlinge, beispielsweise auf Thermoplast-Basis, als kontaktierbare Steckerelemente eingesetzt. Alternativ können auch SMD-Stecker verwendet werden.

Derartige Stecker sind in vielseitiger Variation als Katalogware beziehbar. Um einen Medienschutz der elektronischen Schaltung auch im Steckerbereich zu gewährleisten, ist es allerdings erforderlich, bei einer Kontaktierung des Steckers mit einem Schaltungsträger den Steckerkörper gegenüber einer Umhausung der elektronischen Schaltung abzudichten. Eine solche Abdichtung muss über die Lebensdauer beispielsweise eines Steuergerätes aufrecht gehalten werden. DE102015203592 zeigt eine Elektronikeinheit, welche zwei Leiterplatten umfast, nämlich eine Steckerleiterplatte und eine Baugruppenträgerplatte mit getrennten elektrichen Funktionsbereichen.

DE102008043774 zeigt ein Elektromodul das bezieht sich auf ein Leiterplattenmodul für Steuergeräte, insbesondere für Verbrennungskraftmaschinen.

### Offenbarung der Erfindung

### Vorteile

Der Erfindung liegt die Aufgabe zu Grunde, das Einhausen eines Elektronikmodules mit einem Steckeranschluss zu vereinfachen und dabei die Dichtigkeit im Bereich des Steckeranschlusses zu optimieren.

Diese Aufgabe wird durch ein Elektronikmodul und ein Fertigungsverfahren für ein Elektronikmodul mit den kennzeichnenden Merkmalen der unabhängigen Ansprüche gelöst.

Ausgegangen wird von einem Elektronikmodul, umfassend zumindest einen bestückten Schaltungsträger mit einem Steckeranschluss zur elektrischen Kontaktierung mit einem Gegenstecker. Der Schaltungsträger ist unter Ausbildung einer Schutzumhausung zumindest bereichsweise von zumindest einer verfestigten Umhüllungsmasse umschlossen. Der Steckeranschluss umfasst dabei einen Steckerkörper mit zumindest einem Steckerkragen, wobei der Steckerkörper aus der zumindest einen verfestigten Umhüllungsmasse gebildet ist. Ferner ist durch den Steckerkragen eine Aufnahmeöffnung für den Gegenstecker gebildet, wobei die Aufnahmeöffnung bis zu einem Steckergrund reicht, welcher durch einen von der Umhüllungsmasse freigehaltenen Teilbereich des Schaltungsträgers gebildet ist.

Durch die Einhausung mittels der verfestigten Umhüllungsmasse kann der - eine elektronische Schaltung umfassende - bestückte Schaltungsträger gegen Umwelteinflüsse, wie z.B. Temperatur, Medien, mechanische Einwirkung usw., wirkungsvoll geschützt werden. Auf ein ansonsten übliches separates Gehäuse kann somit verzichtet werden. Ferner ist der Steckerkörper ebenfalls aus einer Umhüllungsmasse gebildet, wodurch beispielsweise ermöglicht ist, einen Steckeranschluss des Elektronikmodules zeitgleich und/oder auf dem gleichen Fertigungsverfahren basierend in einem Arbeitsschritt mit der Schutzumhausung auszubilden. Bevorzugt ist der Steckerkörper mit dem Steckerkragen direkt an die Schutzumhausung angeformt. In einer vorteilhaften Ausführung sind dabei die Schutzumhausung und der Steckerkörper einteilig aus der gleichen verfestigten Umhüllungsmasse gebildet. Dies bietet sich insbesondere dann an, wenn aufgrund des Anwendungsfalles die Anforderungen an die Schutzumhausung durch eine verfestigte Umhüllungsmasse erfüllt sind und die in der Montage und im Betrieb des Elektronikmodules auftretenden Steckerkräfte am Steckeranschluss durch die mechanische Festigkeit der gleichen Umhüllungsmasse schadensfrei aufgenommen werden können. Alternativ sind die Schutzumhausung und der Steckerkörper stoffverbunden und aus unterschiedlichen Umhüllungsmassen gebildet. In diesem Fall kann beispielsweise die Umhüllungsmasse für den Steckerkörper in Hinblick auf besonders hohe Steckerkräfte entsprechend ausgewählt sein. Ein Stoffschluss ergibt sich beispielsweise in sehr einfacher Weise, wenn beide Umhüllungsmassen während eines Fertigungsschrittes in Anlagenkontakt zueinander kommen, wobei zumindest einer der Umhüllungsmassen zu diesem Zeitpunkt noch nicht verfestigt ist, und die Verfestigung dann zeitlich darauf folgend aufgrund eines Verfestigungsprozess, beispielsweise mittels einer Temperaturbehandlung und/oder eines Trocknungsvorgangs und/oder auf anderer Weise chemisch und/oder physikalisch bedingt aktiviert, erfolgt.

Grundsätzlich ergibt sich der große Vorteil, dass bisher erforderliche Dichtungselemente zwischen dem Stecker und einer andersartigen Umhausung nun vollkommen entfallen können. Auf diese Weise sind die Anzahl der Bauteile, die Komplexität des Elektronikmodules und die notwendigen Prozessschritte zur Realisierung eines Elektronikmodules weiter reduziert. Gegenüber den bekannten Lösungen können somit Kosten reduziert werden.

In einer vorteilhaften Ausführungsform des Elektronikmodules steht der Steckerkragen über die Schutzumhausung ab. Dieser kann somit individuell angepasst sein an die Steckergeometrie des Gegensteckers, insbesondere eine Steckerlänge, wobei die Schutzumhausung bevorzugt lediglich einer möglichst kompakten Außengeometrie folgt. Zusätzlich kann der Steckerkragen dadurch in einfacher Weise Befestigungs- und/oder Dichtbereiche aufweisen, die auf eine betriebssichere elektrische mechanische Kontaktierung des Gegensteckers mit dem Steckeranschluss des Elektronikmodules optimiert sind.

In einer bevorzugten Ausführungsform ist der Schaltungsträger als "starrflex"-Leiterplatte oder als "semiflex"-Leiterplatte ausgebildet, umfassend zumindest zwei Leiterplattenbereiche, die in einem Winkel, insbesondere in einem rechten Winkel, zueinander angeordnet sind. Bei einer "semiflex"-Leiterplatte ist der die beiden Leiterplattenbereiche verbindende Umlenkbereich gebildet durch eine partielle Ausdünnung der Leiterplattenstärke, beispielsweise durch eine Flächentieffräsung, wodurch bis zu einem definierten Umlenkradius eine flexible winklige Anordnung der Leiterplattenbereiche ermöglicht ist. Bei einer "starrflex"-Leiterplatte wiederrum sind die beiden starren Leiterplattenbereiche durch einen flexiblen Polyimidabschnitt verbunden. In beiden Ausführungen sind die beiden Leiterplattenbereiche elektrisch miteinander verbunden. Eine derartige Ausführungsform mit unterschiedlich angeordneten Leiterplattenbereichen ermöglicht die Ausrichtung des Steckeranschlusses am Elektronikmodul in einer priorisierten Richtung. So ist ein besonders günstiger Aufbau des Elektronikmodules gegeben durch einen im Vergleich größeren Leiterplattenbereich, welcher bevorzugt im Wesentlichen die elektrischen Bauelemente der elektronischen Schaltung trägt. Der dagegen kleinere Leiterplattenbereich umfasst zumindest oder ausschließlich den Steckeranschluss und legt einen um 90° zum restlichen Elektronikmodul gedrehten Steckeranschluss fest. Eine derartige Ausrichtung eines kontaktierbaren Steckeranschlusses hat sich bereits in vielen herkömmlichen Aufbauten von Steuergeräten bewährt.

Bevorzugt ist Ein besonderer Vorteil zeigt sich in einer Ausführungsform des Elektronikmodules, bei welcher der Schaltungsträger zumindest im Bereich des Steckergrunds einen Auflage- und/oder Abdichtbereich für ein Formwerkzeug aufweist und der Auflage- und/oder Abdichtbereich ausgebildet ist, durch Auflage des Formwerkzeuges zur Ausbildung des Steckerkörpers und/oder der Schutzumhausung den Steckergrund als den von Umhüllungsmasse freigehaltenen Teilbereich des Schaltungsträgers auszubilden. der Auflage-und/oder Dichtbereich eben ausgeführt, was bereits durch die Bauart der meisten standardisierten Schaltungsträger gegeben ist. In einfacher Weise kann somit eine erforderliche Auflage- und/oder Dichtkraft eines Formwerkzeuges auf eine unbestückte Flächenzone des Schaltungsträgers einwirken. Ferner kann die Krafteinwirkung flexibel auf eine entsprechende Fläche angepasst werden, so dass eine Beschädigung des Schaltungsträgers ausgeschlossen werden kann. Zusätzlich lässt sich vorteilhaft erreichen, dass im Steckergrund eine vom Formwerkzeug zum Umhüllungsmaterial abgrenzbare geschützte Bestückungsfläche verbleibt. Bevorzugt ist daher im Steckergrund zumindest ein Steckerkontakt, insbesondere in Form eines Anschlusspins, angeordnet. Die übliche Abdichtung eines Umhüllungsmateriales am Steckerkontakt oder das nachträgliche Einstichen eines Steckerkontaktes in einen Steckerkörper wie bei üblichen separaten spritzgegossenen Steckern kann damit entfallen. Auch bleiben die Anschlussbedingungen am Steckerkontakt optimiert, da an diesen die ansonsten aufgrund von Dichtungsproblemen an umspritzten Steckerkontakten oft auftretenden problematischen Spritzgussfehler, wie beispielsweise abstehende dünnwandige Materialhäute oder Materialanhäufungen, erst gar nicht auftreten können. Insofern sind somit Steckeranschlüsse eines umhausten Elektronikmodules mit hoher Qualitätsgüte ausbildbar.

In einer Weiterbildung des Elektronikmodules ist der Auflage- und/oder Abdichtbereich gebildet durch eine Kupferschicht, eine Goldschicht oder eine Glasfaserlage, welche auf einer Außenseite des Schaltungsträgers angeordnet ist. Damit kann die Dichtwirkung am aufliegenden Formwerkzeug und eine Tragfähigkeit des Schaltungsträgers im Krafteinwirkbereich des Formwerkzeuges weiter erhöht werden. Grundsätzlich kann die Kupfer- bzw. Goldschicht als Metallisierung auf einem Grundmaterial des Schaltungsträgers aufgebracht sein, ebenso kann das Grundmaterial des Schaltungsträgers bereits für die gleiche Funktion geeignet sein sowie alternative gleichwertige Metallisierungen. Bevorzugt ist ein umlaufender Randbereich des Auflage- und/oder Dichtbereiches von verfestigter Umhüllungsmasse überdeckt. Durch diesen Überdeckungsbereich ist der Steckergrund vor Delamination der aufgebrachten Materiallage vorteilhaft geschützt. Weiter bevorzugt sind aufgebrachte Materiallagen als der jeweils dann wirksame Auflage- und/oder Abdichtbereich zumindest im Bereich des zumindest eines Steckerkontaktes mit Abstand ausgespart, insbesondere bei einer Anordnung von mehreren Steckerkontakten, beispielsweise Anschlusspins, um eine elektrische Verschaltung untereinander zu unterbinden.

Ein besonderer Vorteil ergibt sich bei einer Ausführung des Elektronikmodules derart, dass der Schaltungsträger zumindest im Bereich des Steckergrundes eine Leiterstruktur aufweist, welche in einer Zwischenlage oder auf der dem Steckergrund gegenüberliegenden Seite des Schaltungsträgers angeordnet ist und welche mit dem zumindest einen Steckerkontakt kontaktiert ist. Der Auflage-und/oder Dichtbereich kann somit durchgehend ohne Unterbrechungen von ansonsten notwendigerweise abzugrenzenden Leiterstrukturabschnitten ausgeführt sein. Zusätzlich ist die Leiterstruktur aus der Gefahrenzone der Einwirkung eines Formwerkzeugs gebracht, so dass eine Beschädigung bei der Ausbildung der Schutzumhausung und/oder des Steckerkörpers auszuschließen ist.

Zusätzliche Verbesserungen in der Ausführung des Elektronikmodules ergeben sich dadurch, dass der Schaltungsträger im Bereich des Steckerkörpers Durchbrüche aufweist, welche von der Umhüllungsmasse des Steckerkörpers derart durchdrungen sind, dass der Steckerkörper zumindest mechanisch mit dem Schaltungsträger verbunden ist. Steckerkräfte, die beim Ein- und Ausstecken eines Gegensteckers auftreten, können auf diese Weise ohne Beschädigungsgefahr durch das Elektronikmodul aufgenommen werden. Insbesondere kann somit einer Delamination des verfestigten Umhüllungsmaterials infolge von Steckkräften durch einen zusätzlichen Formschluss entgegengewirkt werden. Der Formschluss ist besonders optimiert, wenn auf beiden Seiten des Schaltungsträgers angeordnete Umhüllungsmassen durch die Durchbrüche im Schaltungsträger miteinander stoffschlüssig verbunden sind. Mehrere Durchbrüche sind zueinander beabstandet und bevorzugt in einer regelmäßigen Musteranordnung ausgeführt, insbesondere in einer solchen Anordnung, welche den Steckergrund und/oder den zumindest einen Steckerkontakt umschließt. Ist der Steckeranschluss in einem Randbereich des Schaltungsträgers angeordnet, kann zusätzlich oder alternativ der Steckerkörper einen Randabschnitt des Schaltungsträgers umgreifen. Allgemein können am Steckerkörper zusätzlich Versteifungsrippen ausgeformt sein, welche bis zum Steckerkragen reichen können. Diese erhöhen weiterhin eine mechanische Belastbarkeit des Steckeranschlusses.

Die Erfindung führt auch zu einem Fertigungsverfahren für ein Elektronikmodul, insbesondere in einer der zuvor beschrieben Ausführungsform, umfassend zumindest einen bestückten Schaltungsträger mit einem Steckeranschluss zur elektrischen Kontaktierung mit einem Gegenstecker, wobei der Schaltungsträger unter Ausbildung einer Schutzumhausung zumindest bereichsweise von zumindest einer verfestigten Umhüllungsmasse umschlossen ist und zumindest einen Steckerkontakt umfasst, welcher ausgebildet ist, den Steckeranschluss für den Gegenstecker zu bilden, mit den Verfahrensschritten:
- Einlegen des zumindest einen bestückten Schaltungsträgers in eine Kavität eines Formwerkzeuges,
- Auflage eines Teilelementes des Formwerkezuges auf einem Auflage-und/oder Abdichtbereichs des Schaltungsträgers, welcher den zumindest einen Steckerkontakt vollständig umschließt,
- Einbringen einer verfestigbaren Umhüllungsmasse in die Kavität, wobei zumindest der durch Auflage des Teilelementes des Formwerkzeugs abgegrenzte Teilbereich des Schaltungsträgers von der Umhüllungsmasse freigehalten wird,
- Verfestigen der eingebrachten Umhüllungsmasse unter Ausbildung der Schutzumhausung und eines Steckerkörpers mit einem Steckerkragen im Bereich des Steckerkontaktes.

Die Kavität bildet hierbei eine Außenformgeometrie für das auszubildende Elektronikmodul ab. Das Formwerkzeug ist in der Regel mehrteilig ausgeführt, um im geöffneten Zustand ein Einlegen des bestückten Schaltungsträgers zu ermöglichen. Im geschlossenen Zustand wird der verbleibende Freiraum in der Kavität von eingebrachter Umhüllungsmasse vollständig ausgefüllt. Um den Steckerkontakt vor der Umhüllungsmasse freizuhalten, ist dieser bei einer Auflage des Formwerkzeuges auf dem Schaltungsträger bevorzugt in einer Aussparung des Teilelementes des Formwerkzeuges aufgenommen.

In einer vorteilhaften Ausführungsform des Verfahrens wird durch das Teilelement des Formwerkzeuges zumindest eine Aufnahmeöffnung für den Gegenstecker abgeformt, wobei die Aufnahmeöffnung bis zu einem Steckergrund reicht, welcher durch den von Umhüllungsmasse freigehaltenen Teilbereich des Schaltungsträgers ausgebildet wird. Bevorzugt ist das Teilelement des Formwerkzeuges in Form eines Schiebewerkzeuges ausgebildet, so dass eine sichere Entformung der Aufnahmeöffnung erfolgen kann.

Bevorzugt wird die Umhüllungsmasse durch ein Spritzpress- oder Spritzgießverfahren (Transfer Molding, Injection Moulding), bzw. den zugehörigen Sonderverfahren, eingebracht.

Die dem Auflage- und/oder Abdichtbereich gegenüberliegende Seite des Schaltungsträgers wird vorteilhaft durch Abstützelemente, insbesondere in Form von stehenden oder fahrbaren Pins (sogenannte retractable pins), bevorzugt verfedert, im Formwerkzeug gehalten. Diese können auf diese Weise dann eine durch das Teilelement des Formwerkzeuges in den Schaltungsträger eingeleitete Auflage- und/oder Abdichtkraft durch eine Gegenkraft abstützen und ein Durchbiegen des Schaltungsträgers verhindern.

Grundsätzlich kommen als Umhüllungsmassen Duroplaste, Thermoplaste oder Elastomere in Frage.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine erste Ausführung eines Elektronikmodules in einer Schnittansicht,
- Fig. 2:: ein Elektronikmodul während eins Fertigungsprozess mittels eines Formwerkzeuges in einer schematischen Schnittansicht,
- Fig. 3:: eine Detailansicht einer Auflage- und/oder Dichtfläche für ein Teilelement des Formwerkzeuges am Schaltungsträger,
- Fig. 4:: eine alternative Ausführung eines Elektronikmodules mit einer gegenüber der ersten Ausführung aus Fig. 1 gedreht orientiertem Steckeranschluss in einer Schnittansicht,
- Fig. 5:: eine Weiterbildung eines Elektronikmodules mit Darstellung einer mechanischen Verankerung des Steckerkörpers in Durchbrüchen des Schaltungsträgers.

### Ausführungsformen der Erfindung

In den Figuren sind funktional gleiche Bauelemente jeweils mit gleichen Bezugszeichen gekennzeichnet.

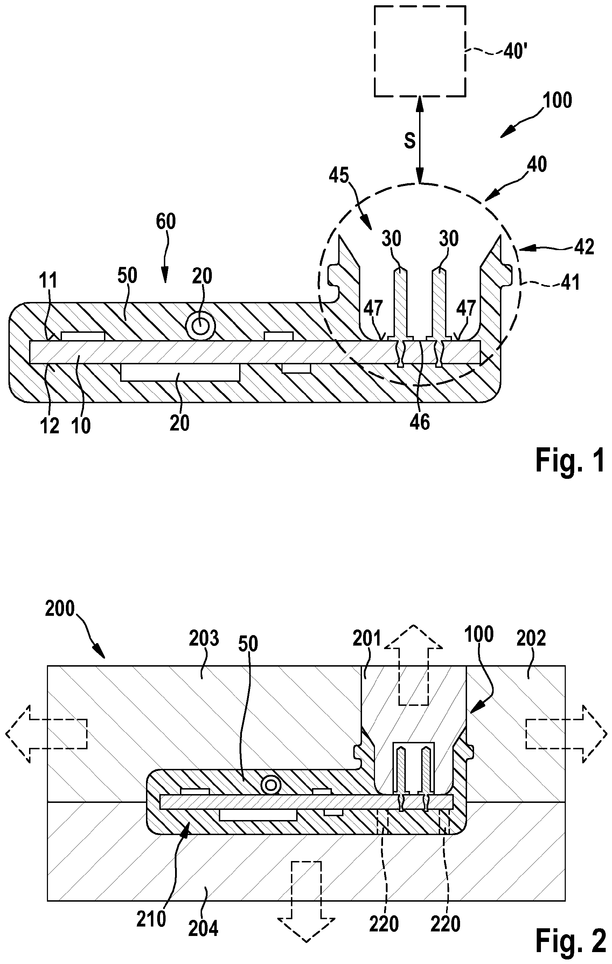

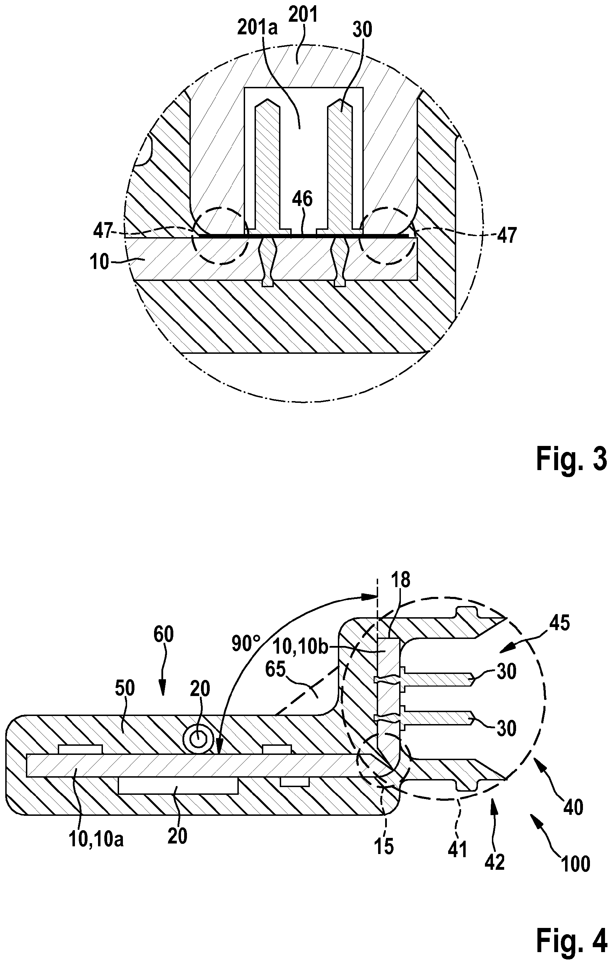

In Fig.1 ist eine erste Ausführung eines Elektronikmodules 100 in einer Schnittansicht gezeigt. Das Elektronikmodul 100 umfasst zumindest einen bestückten Schaltungsträger 10. In dem vorliegenden Ausführungsbeispiel sind elektrische Bauelemente 20 auf eine Oberseite 11 und einer Unterseite 12 des Schaltungsträgers 10 angeordnet und bilden mit einer Leiterstruktur des Schaltungsträgers 10 eine elektronische Schaltung aus. Der bestückte Schaltungsträger 10 ist nahezu vollständig von einer verfestigten Umhüllungsmasse 50 umschlossen. So sind beispielsweise die elektrischen Bauelemente auf der Ober- und der Unterseite 11, 12 von der Umhüllungsmasse 50 vollständig überdeckt. Insgesamt ist durch die Umhüllungsmasse 50 eine Schutzumhausung 60 des Elektronikmodules 100 gebildet. Durch die Schutzumhausung 60 sind die elektronische Schaltung sowie der Schaltungsträger 10 vor Umwelteinflüssen geschützt, beispielsweise vor einer Einwirkung von Temperatur, schädlichen Medien und/oder mechanischer Beanspruchung. Das Elektronikmodul 100 umfasst auch einen Steckeranschluss 40 für einen Gegenstecker 40' (gestrichelt dargestellt). Der Steckeranschluss 40 weist bevorzugt eine Steckrichtung S senkrecht zu der Ober- bzw. Unterseite 11, 12 des Schaltungsträgers 10 auf. Der Steckeranschluss 40 ist im Wesentlichen gebildet durch einen Steckerkörper 41 mit einem Steckerkragen 42 sowie durch zumindest einen Steckerkontakt 30. Der Steckerkörper 41 ist dabei einteilig mit der Schutzumhausung 60 aus der einen verfestigten Umhüllungsmasse 50 ausgebildet und steht über die Schutzumhausung 60 ab. Die Umhüllungsmasse 50 ist beispielsweise ein Thermoplast, ein Duroplast oder ein Elastomer, insbesondere solche, welche für ein Spritzguss- und/oder Spritzpressverfahren geeignet sind. Durch den Steckerkragen 42 ist eine Aufnahmeöffnung 45 gebildet, welche bis zu einem Steckergrund 46 reicht. Der Steckergrund 46 ist dabei gebildet durch einen Teilbereich des Schaltungsträgers 10, welcher freigehalten ist von der Umhüllungsmasse 50. Der Steckergrund 46 ist daher in seinem Randbereich von Seitenflächen der Aufnahmeöffnung 45 umlaufend umschlossen. Insofern ist der von Umhüllungsmasse 50 freigehaltene Teilbereich des Schaltungsträgers 10 ein integral angegliedertes Teilelement des ansonsten aus Umhüllungsmasse 50 gebildeten Steckerkörpers 41. Hierfür weist der Schaltungsträger 10 zumindest im Bereich des Steckergrunds 46 einen Auflage-und/oder Abdichtbereich 47 für ein Formwerkzeug 200 auf, wobei der Auflage-und/oder Dichtbereich ausgebildet ist, durch Auflage des Formwerkzeuges zur Ausbildung des Steckerkörpers 41 und/oder der Schutzumhausung 60 den Steckergrund 46 als den von Umhüllungsmasse 50 freigehaltenen Teilbereich des Schaltungsträgers 10 auszubilden. Dies wird noch in den Erläuterungen zu den Fig. 2 und 3 näher ausgeführt.

Im Ausführungsbeispiel sind des Weiteren eine Vielzahl von Steckerkontakten 30 im Steckergrund 46 angeordnet. Beispielsweise sind die Steckerkontakte 30 als Anschlusspins gebildet, welche von der Oberseite 11 des Schaltungsträgers 10 abstehen und mit ihrem jeweils einem Ende im Schaltungsträger 10 eingelötet oder eingepresst sind unter Ausbildung einer jeweils elektrischen Verbindung mit einer Leiterstruktur des Schaltungsträgers 10. Es sind bevorzugt weitere Anschlusspins in die Zeichenebene hinein auf dem Schaltungsträger 10 angeordnet, so dass der Steckeranschluss 40 mehrere Anschlussreihen, beispielsweise zwei Reihen oder mehr, umfasst.

Die Fig. 2 zeigt das Elektronikmodul 100 während der Herstellung zu einem Fertigungszeitpunkt kurz vor dem Entformen aus einem Formwerkzeug 200. Das Formwerkezug 200 ist bevorzugt mehrteilig aus Teilelementen 201, 202, 203, 204 ausgeführt und umschließt in einem geschlossenen Zustand ein zur Herstellung des Elektronikmodules 100 eingelegten Schaltungsträger 10 innerhalb einer Kavität 210. Im Bereich der Steckerkontakte 30 liegt dabei ein Teilelement 201 des Formwerkzeuges direkt auf der Oberseite 11 des Schaltungsträgers 10 auf. Dabei weist das Teilelement 201 des Formwerkzeuges 200 bevorzugt eine Aussparung 201a auf zur Aufnahme der Steckerkontakte 30 während der Auflage auf dem Schaltungsträger 10. Die Auflage erfolgt auf dem Auflage- und/oder Dichtbereich 47 des Schaltungsträgers 10, welcher insbesondere geschlossen umlaufend um die Steckerkontakte 30 und eben ausgebildet ist. Der Auflage- und/oder Dichtbereich ist in der Fig. 3 nochmals vergrößert dargestellt. Bevorzugt ist der Auflage- und/oder Dichtbereich 47 gebildet durch eine Kupferschicht oder durch eine Glasfaserlage, welche beispielsweise auf der Oberseite 11 des Schaltungsträgers 10 angeordnet ist. Auf diese Weise kann das Teilelement 201 des Formwerkzeuges 200 mit Kraft gegen den Auflage- und/oder Dichtbereich 47 aufdrücken, um in einem anschließenden Spritzgussprozess zur Ausbildung des Steckergrundes 46 den durch Auflage abgedeckten Teilbereich des Schaltungsträgers 10 von der in die Kavität 210 des Formwerkzeuges 200 eingespritzten Umhüllungsmasse 50 freizuhalten. Um die satte und dichte Auflage des Teilelementes 201 des Formwerkzeuges nicht zu gefährden, weist der Schaltungsträger zumindest im Bereich des Steckergrundes 46 eine Leiterstruktur auf, welche in einer Zwischenlage oder auf der dem Steckergrund 46 gegenüberliegenden Seite des Schaltungsträgers 10 angeordnet ist und welche mit dem zumindest einen Steckerkontakt 30 kontaktiert ist. Zusätzlich kann auf der dem Auflage- und/oder Abdichtbereich 47 gegenüberliegenden Seite des Schaltungsträgers 10 verfahrbare und verfederte Abstützelemente 220 als Gegenhalter zu dem Teilelement 201 des Formwerkzeug 201 vorgesehen werden.

Die Umhüllungsmasse 50 wird bevorzugt durch ein Spritzpressverfahren oder durch ein Spritzgussverfahren in die Kavität 210 eingebracht bis der Freiraum zwischen dem Formwerkzeug 200 und dem bestückten Schaltungsträgers 10 vollständig von der Umhüllungsmasse 50 ausgefüllt ist. Auf diese Weise wird die Außengeometrie des Elektronikmoduls 100 ausgebildet, welche die Schutzumhausung 60 und den Steckeranschluss 40 umfasst. Insbesondere wird durch das Teilelement 201 des Formwerkzeuges 200 zumindest die Aufnahmeöffnung 45 für den Gegenstecker 40' abgeformt. Diese reicht bis zu dem Steckergrund 46, welcher durch den von Umhüllungsmasse 50 freigehaltenen Teilbereich des Schaltungsträgers 10 ausgebildet wird. Durch Verfestigen der Umhüllungsmasse 50 durch einen Verfestigungsprozess und dem Öffnen des Formwerkzeugs 200 im Zuge eines Entformvorganges durch Ausfahren aller beweglichen Teilelemente 201, 202, 203, 204 des Formwerkzeuges 200, kann das Elektronikmodul 100 umfassend den Steckeranschluss 40 entnommen werden.

Alternativ kann ein Spritzguss- oder Spritzpressverfahren angewendet werden, bei welchem unterschiedliche Umhüllungsmassen 50 zur Ausbildung des Steckerkörpers 41 aus der einen Umhüllungsmasse und der Schutzumhausung 60 aus der anderen Umhüllungsmasse in die Kavität eingespritzt werden. Ferner bietet sich für bestimmte Anwendungsfälle an, einen Teil der Schutzumhausung 60 oder die gesamte Schutzumhausung 60 mittels eines Fill&Damm-Verfahrens auszubilden, nachdem zuvor der Steckerkörper 41 durch ein Spritzguss- oder Spitzpressverfahren ausgebildet wurde. Bei dem Fill&Damm-Verfahren wird ein auf dem Schaltungsträger 10 angeordnetes Umrahmungselement mit einer verfestigbaren Gussmasse druckfrei vergossen und verfestigt. In beiden Ausführungsvarianten sind der Steckerkörper 41 und die Schutzumhausung 60 nach einem Verfestigungsprozess stoffschlüssig miteinander verbunden.

In der Fig. 4 ist eine alternative Ausführungsform des Elektronikmodules 100 in einer seitlichen Schnittansicht gezeigt. Diese unterscheidet sich ggü. der Ausführung gemäß der Fig. 1 darin, dass der Steckeranschluss 40 um einem Winkel, insbesondere 90° gedreht ist. Dies kann dadurch erreicht werden, dass der Schaltungsträger 10 als "semiflex"-Leiterplatte ausgebildet ist. Hierbei lassen sich ein erster Leiterplattenbereich 10a und ein zweiter Leiterplattenbereich 10b des Schaltungsträgers 10 über einen flexiblen Bereich 15 winklig zueinander anordnet. Nicht gezeigt ist die weitere Möglichkeit für eine solche Anordnung durch eine "starrflex"-Leiterplatte vorzusehen, wobei der flexible Bereich 15 dann durch beispielsweise einen Polyimidabschnitt gebildet ist. Im gezeigten Ausführungsbeispiel weist der erste Leiterplattenbereich 10a alle elektrischen Bauelemente 20 der elektronischen Schaltung auf, wogegen der zweite Leiterplattenbereich 10b lediglich die Komponenten des Steckeranschlusses 40 umfasst. Des Weiteren kann bei beliebiger Ausführungsform des Elektronikmoduls 100 zwischen dem Steckerkörper 41 und der Schutzumhausung 60 zumindest eine oder mehrere Versteifungsrippen 65 ausgeformt sein. Insbesondere beabstandet angeordnet und zumindest einem Abschnitt eines Formverlaufes des Steckerkragens 42 folgend, kann so ein Elektronikmodul 100 mit einem mechanisch sehr belastbaren Steckeranschluss 40 erhalten werden.

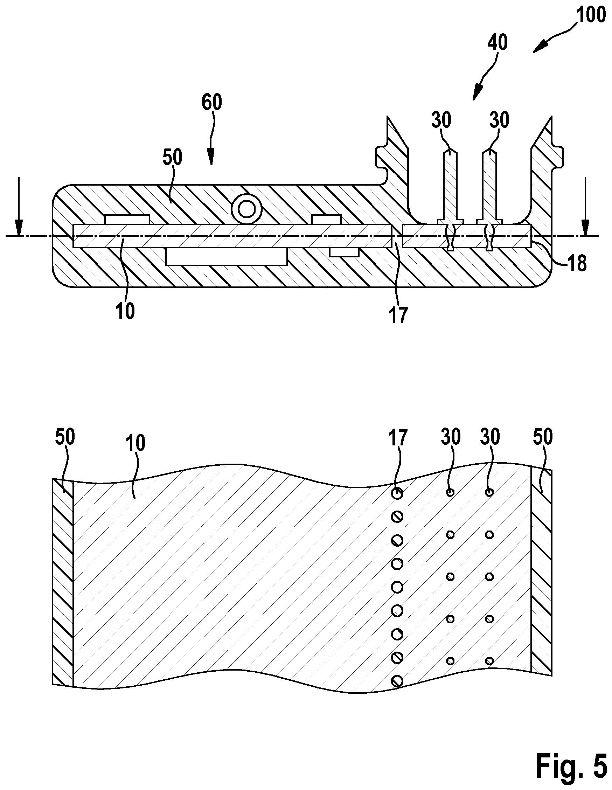

Zusätzlich oder alternativ ist eine mechanische Stabilität auch bei beliebigen Ausführungsformen gegeben, bei welchen der Steckerkörper 41 zusätzlich mechanisch mit dem Schaltungsträger 10 verankert ist. Wie in der oberen Seitenansicht in Fig. 5 am Beispiel der ersten Ausführungsform des Elektronikmodules 100 gezeigt, weist der Schaltungsträger 10 im Bereich des Steckerkörpers 41 Durchbrüche 17 auf, welche von der Umhüllungsmasse 50 des Steckerkörpers 41 durchdrungen sind. Bevorzugt ist die Umhüllungsmasse 50 auf Seiten der Unterseite 12 und der Oberseite 11 des Schaltungsträgers 10 durch die Durchbrüche 17 hindurch miteinander verbunden. Die Durchbrüche 17 können wie in der unteren teilgezeigten Draufsicht der Fig. 5 zueinander beabstandet in einer Musteranordnung vorgesehen sein und die Steckerkontakte 30 bzw. den Steckergrund 46 abschnittsweise oder vollständig umschließen. Ist der Steckeranschluss 40, wie in den bisherigen Beispielen gezeigt, in einem Randbereich des Schaltungsträgers 10 angeordnet, so kann ein unterer Bereich des Steckerkörpers 41 zumindest einen Randabschnitt 18 des Schaltungsträgers 10 umgreifen, um eine mechanische Verstärkung zu erwirken.

## Patentansprüche

1. Elektronikmodul (100), umfassend zumindest einen bestückten Schaltungsträger (10) mit einem Steckeranschluss (40) zur elektrischen Kontaktierung mit einem Gegenstecker (40'), wobei der Schaltungsträger (10) unter Ausbildung einer Schutzumhausung (60) zumindest bereichsweise von zumindest einer verfestigten Umhüllungsmasse (50) umschlossen ist, der Steckeranschluss (40) einen Steckerkörper (41) mit zumindest einem Steckerkragen (42) umfasst, wobei der Steckerkörper (41) aus der zumindest einen verfestigten Umhüllungsmasse (50) gebildet ist und der Steckerkragen (42) eine Aufnahmeöffnung (45) für den Gegenstecker (40') bildet, dadurch gekenzeichnet, dass die Aufnahmeöffnung (45) bis zu einem Steckergrund (46) reicht, welcher durch einen von der Umhüllungsmasse (50) freigehaltenen Teilbereich des Schaltungsträgers (10) gebildet ist.

2. Elektronikmodul (100) nach Anspruch 1,
**dadurch gekennzeichnet, dass**
die Schutzumhausung (60) und der Steckerkörper (41) einteilig aus der gleichen verfestigten Umhüllungsmasse (50) gebildet sind.

3. Elektronikmodul (100) nach Anspruch 1,
**dadurch gekennzeichnet, dass**
die Schutzumhausung (60) und der Steckerkörper (41) stoffverbunden sind und aus unterschiedlichen Umhüllungsmassen (50) gebildet sind.

4. Elektronikmodul (100) nach einem der vorhergehenden Ansprüche,
**dadurch gekennzeichnet, dass**
der Steckerkragen (42) über die Schutzumhausung (60) absteht.

5. Elektronikmodul (100) nach einem der vorhergehenden Ansprüche,
**dadurch gekennzeichnet, dass**
der Schaltungsträger (10) als starrflex-Leiterplatte oder als semiflex-Leiterplatte ausgebildet ist, umfassend zumindest zwei Leiterplattenbereiche (10a, 10b), die in einem Winkel, insbesondere in einem rechten Winkel, zueinander angeordnet sind.

6. Elektronikmodul (100) nach Anspruch 5,
**dadurch gekennzeichnet, dass**
der kleinere Leiterplattenbereich (10b) zumindest den Steckerkörper (41) umfasst.

7. Elektronikmodul (100) nach einem der vorhergehenden Ansprüche,
**dadurch gekennzeichnet, dass**
der Schaltungsträger (10) zumindest im Bereich des Steckergrunds (46) einen Auflage- und/oder Abdichtbereich (47) für ein Formwerkzeug (200, 201) aufweist, welcher ausgebildet ist, durch Auflage des Formwerkzeuges (200, 201) zur Ausbildung des Steckerkörpers (41) und/oder der Schutzumhausung (60) den Steckergrund (46) als den von Umhüllungsmasse (50) freigehaltenen Teilbereich des Schaltungsträgers (10) auszubilden.

8. Elektronikmodul (100) nach Anspruch 7,
**dadurch gekennzeichnet, dass**
der Auflage- und/oder Abdichtbereich (47) gebildet ist durch eine Kupferschicht, Goldschicht oder eine Glasfaserlage, welche auf einer Außenseite (11, 12) des Schaltungsträgers (10) angeordnet ist.

9. Elektronikmodul (100) nach einem der vorhergehenden Ansprüche,
**dadurch gekennzeichnet, dass**
im Steckergrund (46) zumindest ein Steckerkontakt (30), insbesondere in Form eines Anschlusspins, angeordnet ist.

10. Elektronikmodul (100) nach Anspruch 9,
**dadurch gekennzeichnet, dass**
der Schaltungsträger (10) zumindest im Bereich des Steckergrundes (46) eine Leiterstruktur aufweist, welche in einer Zwischenlage oder auf der dem Steckergrund (46) gegenüberliegenden Seite des Schaltungsträgers (10) angeordnet ist und welche mit dem zumindest einen Steckerkontakt (30) kontaktiert ist.

11. Elektronikmodul (100) nach einem der vorhergehenden Ansprüche,
**dadurch gekennzeichnet, dass**
der Schaltungsträger (10) im Bereich des Steckerkörpers (41) Durchbrüche (17) aufweist, welche von der Umhüllungsmasse (50) des Steckerkörpers (41) derart durchdrungen sind, dass der Steckerkörper (41) zumindest mechanisch mit dem Schaltungsträger (10) verbunden ist.

12. Fertigungsverfahren für ein Elektronikmodul (100), nach einem der Ansprüche 1 bis 11, umfassend zumindest einen bestückten Schaltungsträger (10) mit einem Steckeranschluss (40) zur elektrischen Kontaktierung mit einem Gegenstecker (40'), wobei der Schaltungsträger (10) unter Ausbildung einer Schutzumhausung (60) zumindest bereichsweise von zumindest einer verfestigten Umhüllungsmasse (50) umschlossen ist und zumindest einen Steckerkontakt (30) umfasst, welcher ausgebildet ist, den Steckeranschluss (40) für den Gegenstecker (40') zu bilden, mit den Verfahrensschritten:
• Einlegen des zumindest einen bestückten Schaltungsträgers (10) in eine Kavität (210) eines Formwerkzeuges (200),
• Auflage eines Teilelementes (201) des Formwerkezuges (200) auf einem Auflage- und/oder Abdichtbereichs (47) des Schaltungsträgers (10), welcher den zumindest einen Steckerkontakt (41) vollständig umschließt,
• Einbringen einer verfestigbaren Umhüllungsmasse (50) in die Kavität (210), wobei zumindest der durch Auflage des Teilelementes (201) des Formwerkzeugs (200) abgegrenzte Teilbereich (201) des Schaltungsträgers (10) von der Umhüllungsmasse (50) freigehalten wird,
• Verfestigen der eingebrachten Umhüllungsmasse (50) unter Ausbildung der Schutzumhausung (60) und eines Steckerkörpers (41) mit einem Steckerkragen (42) im Bereich des Steckerkontaktes (30).
**dadurch gekennzeichnet, dass** durch das Teilelement (201) des Formwerkzeuges (200) zumindest eine Aufnahmeöffnung (45) für den Gegenstecker (40') abgeformt wird, wobei die Aufnahmeöffnung (45) bis zu einem Steckergrund (46) reicht, welcher durch den von Umhüllungsmasse (50) freigehaltenen Teilbereich des Schaltungsträgers (10) ausgebildet wird.

13. Fertigungsverfahren nach einem der Ansprüche 12 oder 13,
**dadurch gekennzeichnet, dass**
die Umhüllungsmasse (50) durch ein Spritzpressverfahren oder durch ein Spritzgussverfahren eingebracht wird.

14. Fertigungsverfahren nach Anspruch 14,
**dadurch gekennzeichnet, dass**
die dem Auflage- und/oder Abdichtbereich (47) gegenüberliegende Seite des Schaltungsträgers (11, 12) durch Abstützelemente (220) im Formwerkzeug (200) gehalten wird zum Abstützen einer durch das Teilelement (201) des Formwerkzeuges (200) in den Schaltungsträger (10) eingeleitete Auflage-und/oder Abdichtkraft.

## Claims

1. Electronics module (100), comprising at least one populated circuit carrier (10) with a plug connection (40) for electrical contact-connection to a mating plug (40'), wherein the circuit carrier (10) is surrounded at least in regions by at least one solidified encapsulation compound (50) so as to form a protective enclosure (60),
the plug connection (40) comprises a plug body (41) with at least one plug collar (42), wherein the plug body (41) is formed from the at least one solidified encapsulation compound (50) and the plug collar (42) forms a receiving opening (45) for the mating plug (40'), **characterized in that** the receiving opening (45) extends as far as a plug base (46) which is formed by a subregion of the circuit carrier (10) kept free of the encapsulation compound (50) .

2. Electronics module (100) according to Claim 1, **characterized in that**
the protective enclosure (60) and the plug body (41) are formed in one piece from the same solidified encapsulation compound (50).

3. Electronics module (100) according to Claim 1, **characterized in that**
the protective enclosure (60) and the plug body (41) are materially bonded and are formed from different encapsulation compounds (50).

4. Electronics module (100) according to one of the preceding claims,
**characterized in that**
the plug collar (42) projects beyond the protective enclosure (60).

5. Electronics module (100) according to one of the preceding claims,
**characterized in that**
the circuit carrier (10) is in the form of a rigid-flex printed circuit board or in the form of a semi-flex printed circuit board, comprising at least two printed circuit board regions (10a, 10b) which are arranged at an angle, in particular at a right angle, with respect to one another.

6. Electronics module (100) according to Claim 5,
**characterized in that**
the smaller printed circuit board region (10b) comprises at least the plug body (41).

7. Electronics module (100) according to one of the preceding claims,
**characterized in that**
the circuit carrier (10) has a support and/or sealing region (47) for a mould (200, 201) at least in the region of the plug base (46), which support and/or sealing region is designed, by supporting the mould (200, 201) for forming the plug body (41) and/or the protective enclosure (60), to form the plug base (46) as the subregion of the circuit carrier (10) kept free of the encapsulation compound (50).

8. Electronics module (100) according to Claim 7,
**characterized in that**
the support and/or sealing region (47) is formed by a copper layer, gold layer or a glass-fibre layer which is arranged on an outer side (11, 12) of the circuit carrier (10) .

9. Electronics module (100) according to one of the preceding claims,
**characterized in that**
at least one plug contact (30), in particular in the form of a connection pin, is arranged in the plug base (46).

10. Electronics module (100) according to Claim 9,
**characterized in that**
the circuit carrier (10) has a conductor structure at least in the region of the plug base (46), which conductor structure is arranged in an intermediate layer or on the side of the circuit carrier (10) situated opposite the plug base (46) and is contact-connected to the at least one plug contact (30).

11. Electronics module (100) according to one of the preceding claims,
**characterized in that**
the circuit carrier (10) has apertures (17) in the region of the plug body (41), the encapsulation compound (50) of the plug body (41) passing through the apertures in such a way that the plug body (41) is at least mechanically connected to the circuit carrier (10).

12. Production method for an electronics module (100) according to one of Claims 1 to 11, comprising at least one populated circuit carrier (10) with a plug connection (40) for electrical contact-connection to a mating plug (40'), wherein the circuit carrier (10) is surrounded at least in regions by at least one solidified encapsulation compound (50) so as to form a protective enclosure (60) and comprises at least one plug contact (30) which is designed to form the plug connection (40) for the mating plug (40'), comprising the method steps of:
• inserting the at least one populated circuit carrier (10) into a cavity (210) of a mould (200),
• placing a component element (201) of the mould (200) on a support and/or sealing region (47) of the circuit carrier (10), which region completely surrounds the at least one plug contact (41),
• introducing a solidified encapsulation compound (50) into the cavity (210), wherein at least the subregion (201) of the circuit carrier (10) delimited by support of the component element (201) of the mould (200) is kept free of the encapsulation compound (50),
• solidifying the introduced encapsulation compound (50) so as to form the protective enclosure (60) and a plug body (41) with a plug collar (42) in the region of the plug contact (30),
**characterized in that**
at least one receiving opening (45) for the mating plug (40') is moulded by the component element (201) of the mould (200), wherein the receiving opening (45) extends as far as a plug base (46) which is formed by the subregion of the circuit carrier (10) kept free of encapsulation compound (50).

13. Production method according to either of Claims 12 and 13,
**characterized in that**
the encapsulation compound (50) is introduced by a transfer moulding process or by an injection moulding process.

14. Production method according to Claim 14,
**characterized in that**
the side of the circuit carrier (11, 12) situated opposite the support and/or sealing region (47) is held in the mould (200) by supporting elements (220) for supporting a support and/or sealing force introduced into the circuit carrier (10) by the component element (201) of the mould (200).

## Revendications

1. Module électronique (100), comprenant au moins un support de circuit équipé (10) avec une connexion à fiche (40) pour la mise en contact électrique avec une contre-fiche (40'), le support de circuit (10) étant entouré au moins par zones d'au moins une masse d'enrobage solidifiée (50) en formant une enveloppe de protection (60),
la connexion à fiche (40) comprenant un corps de fiche (41) avec au moins un collet de fiche (42), le corps de fiche (41) étant formé par l'au moins une masse d'enrobage solidifiée (50) et le collet de fiche (42) formant une ouverture de réception (45) pour la contre-fiche (40'), **caractérisé en ce que** l'ouverture de réception (45) s'étend jusqu'à un fond de fiche (46), qui est formé par une zone partielle du support de circuit (10) maintenue exempte de la masse d'enrobage (50) .

2. Module électronique (100) selon la revendication 1,
**caractérisé en ce que**
l'enveloppe de protection (60) et le corps de fiche (41) sont formés d'une seule pièce par la même masse d'enrobage solidifiée (50).

3. Module électronique (100) selon la revendication 1,
**caractérisé en ce que**
l'enveloppe de protection (60) et le corps de fiche (41) sont liés par le matériau et sont formés par des masses d'enrobage différentes (50).

4. Module électronique (100) selon l'une quelconque des revendications précédentes,
**caractérisé en ce que**
le collet de fiche (42) fait saillie au-dessus de l'enveloppe de protection (60).

5. Module électronique (100) selon l'une quelconque des revendications précédentes,
**caractérisé en ce que**
le support de circuit (10) est configuré sous forme de carte de circuit imprimé flex-rigide ou sous forme de carte de circuit imprimé semiflex, comprenant au moins deux zones de carte de circuit imprimé (10a, 10b), qui sont agencées selon un angle, notamment selon un angle droit, l'une par rapport à l'autre.

6. Module électronique (100) selon la revendication 5,
**caractérisé en ce que**
la zone de carte de circuit imprimé la plus petite (10b) comprend au moins le corps de fiche (41).

7. Module électronique (100) selon l'une quelconque des revendications précédentes,
**caractérisé en ce que**
le support de circuit (10) présente, au moins dans la zone du fond de fiche (46), une zone d'appui et/ou d'étanchéité (47) pour un outil de moulage (200, 201), qui est configurée pour former, par appui de l'outil de moulage (200, 201) pour la formation du corps de fiche (41) et/ou de l'enveloppe de protection (60), le fond de fiche (46) en tant que zone partielle du support de circuit (10) maintenue exempte de masse d'enrobage (50) .

8. Module électronique (100) selon la revendication 7,
**caractérisé en ce que**
la zone d'appui et/ou d'étanchéité (47) est formée par une couche de cuivre, une couche d'or ou une couche de fibres de verre, qui est agencée sur un coté extérieur (11, 12) du support de circuit (10).

9. Module électronique (100) selon l'une quelconque des revendications précédentes,
**caractérisé en ce que**
au moins un contact de fiche (30), notamment sous la forme d'une broche de connexion, est agencé dans le fond de fiche (46).

10. Module électronique (100) selon la revendication 9,
**caractérisé en ce que**
le support de circuit (10) présente, au moins dans la zone du fond de fiche (46), une structure conductrice, qui est agencée dans une couche intermédiaire ou sur le côté du support de circuit (10) opposé au fond de fiche (46) et qui est en contact avec l'au moins un contact de fiche (30).

11. Module électronique (100) selon l'une quelconque des revendications précédentes,
**caractérisé en ce que**
le support de circuit (10) présente, dans la zone du corps de fiche (41), des percées (17) qui sont traversées par la masse d'enrobage (50) du corps de fiche (41) de telle sorte que le corps de fiche (41) est relié au moins mécaniquement au support de circuit (10) .

12. Procédé de fabrication pour un module électronique (100), selon l'une quelconque des revendications 1 à 11, comprenant au moins un support de circuit équipé (10) avec une connexion à fiche (40) pour la mise en contact électrique avec une contre-fiche (40'), le support de circuit (10) étant entouré au moins par zones d'au moins une masse d'enrobage solidifiée (50) en formant une enveloppe de protection (60) et comprenant au moins un contact de fiche (30) qui est configuré pour former la connexion de fiche (40) pour la contre-fiche (40'), comprenant les étapes de procédé suivantes :
- la mise en place de l'au moins un support de circuit équipé (10) dans une cavité (210) d'un outil de moulage (200),
- l'appui d'un élément partiel (201) de l'outil de moulage (200) sur une zone d'appui et/ou d'étanchéité (47) du support de circuit (10), qui entoure entièrement l'au moins un contact de fiche (41),
- l'introduction d'une masse d'enrobage solidifiable (50) dans la cavité (210), au moins la zone partielle (201) du support de circuit (10) délimitée par l'appui de l'élément partiel (201) de l'outil de moulage (200) étant maintenue exempte de la masse d'enrobage (50),
- la solidification de la masse d'enrobage introduite (50) en formant l'enveloppe de protection (60) et un corps de fiche (41) avec un collet de fiche (42) dans la zone du contact de fiche (30),
**caractérisé en ce que**
au moins une ouverture de réception (45) pour la contre-fiche (40') est formée par l'élément partiel (201) de l'outil de moulage (200), l'ouverture de réception (45) s'étendant jusqu'à un fond de fiche (46) qui est formé par la zone partielle du support de circuit (10) maintenue exempte de masse d'enrobage (50) .

13. Procédé de fabrication selon l'une quelconque des revendications 12 ou 13,
**caractérisé en ce que**
la masse d'enrobage (50) est introduite par un procédé de moulage par transfert ou par un procédé de moulage par injection.

14. Procédé de fabrication selon la revendication 14,
**caractérisé en ce que**
le côté du support de circuit (11, 12) opposé à la zone d'appui et/ou d'étanchéité (47) est maintenu dans l'outil de moulage (200) par des éléments de support (220) pour supporter une force d'appui et/ou d'étanchéité introduite dans le support de circuit (10) par l'élément partiel (201) de l'outil de moulage (200) .
